# EUROPEAN PATENT APPLICATION

(11) **EP 4 830 851 A1**
(43) Date of publication of application: **28.10.2026**
(21) Application number: 26171859.7
(22) Date of filing: 13.04.2026
(51) Int. Cl.: B22F 7/06, C09J 9/02, H01B 1/22

(54) **SINTERING-BONDING SHEET**

(30) Priority: 17.04.2025 JP 2025068394
(71) Applicant: Nitto Denko Corporation, Ibaraki-shi, Osaka 567-8680 (JP)
(72) Inventor: Fukamichi, Yuichi, Ibaraki-shi, Osaka, 567-8680 (JP); Miyazaki, Yoshikazu, Ibaraki-shi, Osaka, 567-8680 (JP)
(74) Representative: Grünecker Patent- und Rechtsanwälte PartG mbB

(57) **Abstract**

This sintering-bonding sheet includes sinterable particles containing a conductive metal, an organic binder, and an amine-based additive, wherein a bonding strength after sintering at 230°C under 15 MPa for 5 minutes is 50 MPa or higher.

## Description

### BACKGROUND OF THE INVENTION

### Technical Field

The present invention relates to a sintering-bonding sheet.

### Background Art

There is an increasing demand for a power semiconductor to which silicon carbide (SiC) or gallium nitride (GaN) is applied as a semiconductor material and which can handle a high current and a high voltage. The power semiconductor is required to be stably usable even during an operation in which heat is generated by a high current and a temperature becomes high.

As a method of die-bonding a semiconductor chip or the like to a support substrate of a power semiconductor, etc., a method has been proposed that secures electrical connection and mechanical bonding using sinterable particles containing a conductive metal such as silver or copper in addition to conventionally known solder, paste, or the like (JP 2024-010136 A). For the bonding using the sinterable particles, a semiconductor chip is placed on a support substrate coated with a composition containing the sinterable particles and a solvent and the like and heated to volatilize the solvent and the like. Also, sintering of the sinterable particles proceeds to form a sintered layer between the support substrate and the semiconductor chip.

In the bonding using the sinterable particles described above, when a composition containing sinterable particles is applied onto a support substrate, it is difficult to form a bonding layer having a uniform thickness, and it tends to be difficult to uniformly promote sintering of the sinterable particles. From such a viewpoint, a sheet-like bonding material has been proposed that can maintain a predetermined shape at normal temperature, such as a sheet-like bonding material containing sinterable particles described in WO 2008/065728.

### SUMMARY OF INVENTION

In the sheet-like sintering-bonding sheet containing sinterable particles, when the sintering temperature is set to a low temperature such as 230°C, thermal decomposition of the binder or the like contained in the sheet tends to be difficult to sufficiently proceed. For example, residues other than the sinterable particles may remain in the sintered body after sintering, and it tends to be difficult to maintain the bonding reliability for the bonded body after bonding by low-temperature sintering.

Thus, the present invention addresses the problem of providing a sintering-bonding sheet including sinterable particles and an organic binder such that high bonding reliability is easily maintained even at a low sintering temperature.

The present inventors have conducted intensive research to solve the above problems and as a result, have found that the above problems can be solved. Then, the present invention having the following items has been completed.

Specifically, the present invention encompasses the following items.
[1] A sintering-bonding sheet including sinterable particles containing a conductive metal, an organic binder, and an amine-based additive, wherein
   a bonding strength after sintering at 230°C under 15 MPa for 5 minutes is 50 MPa or higher.
[2] The sintering-bonding sheet according to [1], wherein the organic binder contains polyethylene carbonate.
[3] The sintering-bonding sheet according to [1] or [2], wherein the amine-based additive contains an amine represented by the following formula (1): 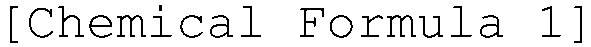 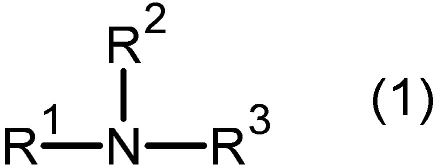
   wherein in the above formula (1), R¹, R², and R³ each represent a C₁₋₃ hydroxyalkyl group or a C₁₋₅ alkyl group,
   two or more of R¹, R², and R³ represent a C₁₋₃ hydroxyalkyl group, and
   when any two of R¹, R², and R³ represent the hydroxyalkyl group, one other than the hydroxyalkyl group represents a C₁₋₅ alkyl group.
[4] The sintering-bonding sheet according to any one of [1] to [3], wherein the amine-based additive has a content of 1 to 20 mass% based on 100 mass% of the organic binder.
[5] The sintering-bonding sheet according to any one of [1] to [4], wherein the amine-based additive has a boiling point of 200 to 400°C.
[6] The sintering-bonding sheet according to any one of [3] to [5], wherein at least one of R¹, R², and R³ represents a C₂₋₃ hydroxyalkyl group.
[7] The sintering-bonding sheet according to any one of [1] to [6], wherein the amine-based additive contains at least one compound selected from the group consisting of triethanolamine and N-butyldiethanolamine.
[8] The sintering-bonding sheet according to any one of [1] to [7], wherein the sinterable particles are copper particles.
[9] A sintering-bonding sheet-attached dicing tape including:
   a dicing tape including a base material and an adhesive layer laminated on the base material; and
   the sintering-bonding sheet according to any one of [1] to [8], the sheet being laminated on the adhesive layer.

The present invention can provide a sintering-bonding sheet in which thermal decomposition of a binder or the like easily proceeds even at a low sintering temperature and high bonding reliability is easily maintained. Since the sintering temperature is low in the sintering-bonding sheet of the present invention, thermal damage caused by sintering during bonding to a bonding target or the like other than the sintering-bonding sheet can be reduced.

### BRIEF DESCRIPTION OF DRAWINGS

FIG. 1 is a schematic cross-sectional view showing an example of a method of measuring bonding strength in an embodiment;
FIG. 2 is a schematic cross-sectional view showing an example of a sintering-bonding sheet-attached dicing tape in an embodiment;
FIG. 3A is a schematic cross-sectional view showing a part of the step of a semiconductor production method using a sintering-bonding sheet-attached dicing tape in an embodiment;
FIG. 3B is a schematic cross-sectional view showing another part of the step of the semiconductor production method using a sintering-bonding sheet-attached dicing tape in the embodiment;
FIG. 3C is a schematic cross-sectional view showing still another part of the step of the semiconductor production method using a sintering-bonding sheet-attached dicing tape in the embodiment; and
FIG. 3D is a schematic cross-sectional view showing still another part of the step of the semiconductor production method using a sintering-bonding sheet-attached dicing tape in the embodiment.

### DESCRIPTION OF EMBODIEMENTS

### (Sintering-bonding sheet)

The sintering-bonding sheet can be used for sintering and bonding between bonding targets such as a semiconductor chip and a support substrate, and it is easy to make uniform the thickness of a sintered layer formed between the bonding targets due to a shape in which a predetermined thickness is maintained, and it is easy to uniformly promote sintering. Thus, it is easy to achieve both good handleability as a sheet and highly reliable bonding.

Note that the dimension and the plan view shape of the sintering-bonding sheet are not particularly limited. The shape in plan view may be any size and shape such as a rectangular shape or a circular shape in accordance with each process or device for the semiconductor production apparatus. The dimension and the plan view shape of the sintering-bonding sheet may be the same as or substantially the same as the dimension and the plan view shape of a bonding target such as a semiconductor chip.

This sintering-bonding sheet of the present invention includes sinterable particles containing a conductive metal, an organic binder, and an amine-based additive, wherein a bonding strength after sintering at 230°C under 15 MPa for 5 minutes is 50 MPa or higher. Such a sintering-bonding sheet makes it possible to sufficiently promote thermal decomposition of a binder or the like during sintering while reducing thermal damage given to other materials such as a bonding target during sintering of the sintering-bonding sheet, and bonding reliability is easily maintained. Therefore, the sintering-bonding sheet according to this embodiment is easily applied to, for example, a case where a sealing package protected by a resin such as epoxy is bonded as a bonding target.

According to the sintering-bonding sheet of the present invention, the bonding strength of 50 MPa or more can be maintained even after sintering at a low temperature such as 230°C, and bonding can be implemented without performing a high-temperature sintering step. Thus, a bonding target, such as a sealing package, having a relatively low heat resistant temperature as described above can also be bonded while suppressing thermal damage.

### <Bonding strength>

The bonding strength is the bonding strength after sintering at 230°C and 15 MPa for 5 minutes.

The bonding strength is preferably 50 MPa or more, more preferably 60 MPa or more, and particularly preferably 70 MPa or more. The upper limit of the bonding strength is not particularly limited, but is preferably 100 MPa or less.

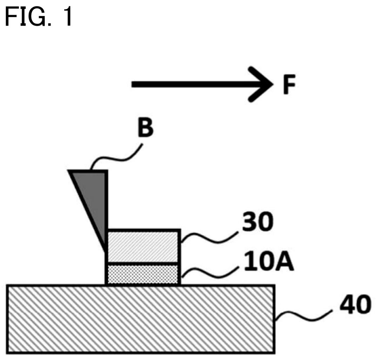

As shown in FIG. 1, after sintering, the bonding strength can be measured as shear stress on a bonded body including a sintered body 10A of the sintering-bonding sheet and a bonding target such as a semiconductor wafer (semiconductor chip) 30 and/or a support substrate 40. The shear stress is the maximum stress when a load is applied using the blade B in the shear direction in the bonded body bonded via the sintered body 10A. In addition, the bonding strength is the bonding strength after the sintering-bonding sheet is sintered at 230°C and 15 MPa and is bonded to a bonding target.

The bonding target using the sintering-bonding sheet according to this embodiment is not limited to a substrate and a semiconductor chip. The bonding of interest may be, for example, bonding between a chip and a clip or bonding between a substrate and a heat sink. The bonding target may further include various transistors, diodes, thyristors, sensors, lead frames, and other various members.

The bonding target may have a lamination surface with the sintered body made of a metal such as copper, nickel, silver (Ag), gold (Au), palladium (Pd), platinum (Pt), lead (Pb), tin (Sn), or cobalt (Co), or an alloy thereof. From the viewpoint of easily realizing the above bonding strength, copper, nickel, silver, gold, or an alloy thereof is preferable, copper, silver, or gold is more preferable, and copper or silver is particularly preferable.

Examples of the material having such a metal or alloy include a chip, a substrate, a heat sink, a clip, a wire, and other members including a metal or alloy layer by plating, lamination, or the like.

### <Amine-based additive>

The present inventors have found that when the sintering-bonding sheet contains an amine-based additive, it is easy to maintain the bonding reliability even in the case of sintering at a low temperature. The reason why the bonding reliability in the case of low-temperature sintering is easily maintained as described above is considered to be that when the organic binder is thermally decomposed at the time of sintering, the amine-based additive acts as a basic catalyst and functions to promote the hydrolysis of the binder. According to the sintering-bonding sheet of the present invention, it is considered that even when the sintering temperature is set to a low temperature such as 230°C as described above, the organic binder is sufficiently thermally decomposed, and residues hardly remain in the sintered body.

The type of the amine-based additive is not particularly limited, and examples thereof include optionally substituted aliphatic amines, aromatic amines, heterocyclic amines, and derivatives thereof. The amine-based additive preferably contains an optionally substituted aliphatic amine.

The amine-based additive preferably contains an alcoholamine having a hydroxyalkyl group and an amino group. This is because the hydroxy group in the alcoholamine easily forms a hydrogen-bond-mediated pseudo crosslinking with the polar group in the organic binder at the time of forming the sintering-bonding sheet, so that the sheet properties are easily reinforced. In particular, when the organic binder contains polyethylene carbonate, it is preferable that the organic binder contains an alcoholamine. This can easily reinforce the above-mentioned sheet properties and can impart flexibility, so that an easy-to-handle sheet can be produced.

Examples of the amine-based additive include an amine represented by the following (1). 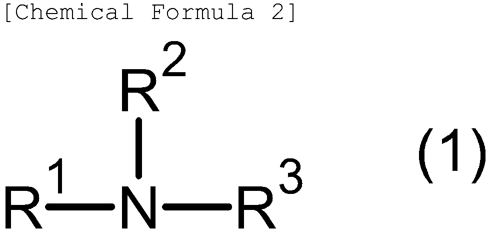
wherein in the above formula (1), R¹, R², and R³ each represent a C₁₋₃ hydroxyalkyl group or a C₁₋₅ alkyl group,
and two or more of R¹, R², and R³ represent a C₁₋₃ hydroxyalkyl group.

This is because the thermal decomposition of the organic binder at the time of sintering is more easily promoted. When an amine having two or more hydroxyalkyl groups is contained as described above, thermal decomposition of PEC is particularly easily promoted when polyethylene carbonate (PEC) is contained as an organic binder as described later.

When any two of R¹, R², and R³ represent a C₁₋₃ hydroxyalkyl group, one other than the hydroxyalkyl group preferably represents a C₁₋₅ alkyl group. This is because the thermal decomposition of the organic binder during sintering described above is easily promoted.

More preferred is triethanolamine in which all of R¹, R², and R³ represent a C₁₋₃ hydroxyalkyl group. This is because, while the thermal decomposition of the organic binder during sintering is promoted, the sinterable particles are less likely to leak (the sinterable particles easily maintain a predetermined shape during sintering and bonding, and are less likely to deform or protrude from between adherends) from between adherends (e.g., a semiconductor chip, a substrate) during sintering and bonding.

It is preferable that at least one of R¹, R², and R³ represents a C₂₋₃ hydroxyalkyl group, and it is more preferable that two or more of R¹, R², and R³ represent a C₂₋₃ hydroxyalkyl group. A hydroxyalkyl group having 2 or more carbon atoms may be used. In this case, the hydroxyalkyl group and a bond in the organic binder form a pseudo-crosslink when a sintering-bonding sheet is formed, so that sheet properties are easily reinforced. This is particularly suitable when the organic binder is polyethylene carbonate.

Examples of the C₁₋₃ hydroxyalkyl group include a hydroxymethyl group, a hydroxyethyl group, and a hydroxypropyl group.

It is more preferable that at least one of R¹, R², and R³ represents a hydroxyethyl group, and it is particularly preferable that two or more of R¹, R², and R³ represent a hydroxyethyl group.

Examples of the C₁₋₅ alkyl group include a methyl group, an ethyl group, an n-propyl group, an isopropyl group, an n-butyl group, an iso-butyl group, a tert-butyl group, and an n-pentyl group.

It is preferable that at least one of R¹, R², and R³ represents a C₂₋₃ alkyl group, and it is more preferable that two or more of R¹, R², and R³ represent a C₂₋₃ alkyl group.

It is still more preferable that at least one of R¹, R², and R³ represents an n-butyl group, and it is particularly preferable that one of R¹, R², and R³ represents an n-butyl group.

Examples of the amine-based additive described above include N-methyldiethanolamine, N-ethyldiethanolamine, N-butyldiethanolamine, triethanolamine, and triisopropanolamine.

The amine-based additive preferably contains at least one selected from the group consisting of triethanolamine, N-butyldiethanolamine, and triisopropanolamine, and more preferably contains at least one selected from the group consisting of triethanolamine and N-butyldiethanolamine.

The content of the amine-based additive is, for example, 1.5 to 20 mass% and preferably 2.0 to 15 mass% based on 100 mass% of the organic binder. When the content is within the above range, it is easy to prevent the amine-based additive from remaining as a residue after the sintering-bonding sheet is sintered while maintaining the bonding reliability in the case of low-temperature sintering.

The content of the amine-based additive is more preferably 2.5 mass% or more and particularly preferably 5.0 mass% or more. In addition, the content of the amine-based additive is more preferably 20 mass% or less and particularly preferably 10 mass% or less.

The boiling point of the amine-based additive is preferably 200 to 400°C at normal pressure (1 atm). When the boiling point is lower than 200°C, the amine-based additive tends to be easily burned out in a short time before the thermal decomposition of the organic binder is promoted when the sintering-bonding sheet is sintered. In addition, when the boiling point is higher than 400°C, it tends to be difficult to set the flexibility and handling of the sheet within appropriate ranges when the sintering-bonding sheet is formed.

The boiling point of the amine-based additive is more preferably 200°C or higher and particularly preferably 250°C or higher. In addition, the boiling point of the amine-based additive is more preferably 400°C or less and particularly preferably 350°C or less.

### <Sinterable particles>

The sinterable particles contain a conductive metal. The sinterable particles are particles that can be sintered when heated to a sintering-bonding temperature (e.g., about 300°C), and examples thereof include gold Au, silver Ag, copper Cu, palladium Pd, tin Sn, nickel Ni, alloys of two or more kinds of these metals, and metal oxides thereof. The sinterable particles preferably contain any one or more kinds of silver particles, copper particles, silver oxide particles, and copper oxide particles. This is because a strong sintered layer is easily formed at the time of sintering and bonding. In addition, it is more preferable that the sinterable particles contain silver particles or copper particles from the viewpoint of easily forming a sintered layer having high conductivity and thermal conductivity at the time of sintering and bonding. The sinterable particles are particularly preferably copper particles from the viewpoint of easily suppressing ion migration and insulation failure due to ion migration and easily improving the reliability of the semiconductor substrate. In addition, when the sinterable particles are copper particles and when the base material or the like as a bonding target is copper, a difference caused by expansion or contraction due to heat is less likely to occur because of the same kind of metal, and the bonding reliability is easily improved.

The sinterable particles used are preferably particles obtained by surface-treating the surface of the conductive metal with an organic film, a polymer, or the like. When the sinterable particles are surface-treated, uniform dispersibility of the sinterable particles in the sintering-bonding sheet is easily maintained, and deterioration of the conductive metal due to surface oxidation or the like is readily suppressed. The surface treatment agent for the conductive metal is not particularly limited, and an appropriate surface treatment agent may be selected according to the type of metal. Examples of the surface treatment agent for the conductive metal include: polymers having a carboxy group, a sulfonic acid group, a phosphoric acid group, an amino group, an imino group, an ammonium group, and/or the like; various nonionic surfactants; and polymer protective colloids.

The purpose of the surface treatment of the conductive metal is not particularly limited, and it is preferable to apply a surface treatment agent suitable for the purpose according to the type of the conductive metal. For example, as the surface treatment agent in the case where the conductive metal is silver, a wide variety of materials can be applied as long as the material is likely to be detached (to disappear) in the sintering step. On the other hand, when the conductive metal is copper, copper tends to be easily oxidized, and copper oxide tends to be hardly removed when oxidized. For this reason, as a copper surface treatment agent, the covering property tends to be emphasized so that the oxidation of copper can be reliably suppressed.

The average particle diameter D50 of the sinterable particles may be 10,000 nm or less, 3000 nm or less, 1000 nm or less, or 300 nm or less. This is because when the average particle diameter is less than or equal to the above average particle diameter, it is easy to ensure the smoothness of the surface of the sintering-bonding sheet. In addition, the average particle diameter D50 of the sinterable particles may be 1 nm or more, 10 nm or more, or 50 nm or more. This is because when the average particle diameter is the above average particle diameter or more, it is easy to maintain a state in which the sinterable particles are uniformly dispersed in the sintering-bonding sheet or the composition for forming the sheet. Note that the average particle diameter D50 herein is a volume-based average particle diameter.

The average particle diameter of the sinterable particles can be measured by observation performed using a scanning electron microscope (SEM). Specifically, it can be calculated based on image data obtained by cooling and cutting a sheet containing sinterable particles, and imaging an exposed cross-section with a field emission scanning electron microscope SU8020 (manufactured by Hitachi High-Technologies Corporation). Examples of the imaging conditions include an acceleration voltage of 5 kV and a magnification of 50,000 times. The image data may be binarized using image analysis software ImageJ and used for calculation of the average particle diameter.

The content percentage of the sinterable particles in the sintering-bonding sheet is preferably 85 to 98 mass%, more preferably 87 to 98 mass%, and particularly preferably 88 to 98 mass%. Within the above range, the bonded portion after sintering easily maintains high thermal conductivity, and the sinterable particles are less likely to leak (the sinterable particles easily maintain a predetermined shape during sintering and bonding, and are less likely to deform or protrude from between adherends) from between adherends (e.g., a semiconductor chip, a substrate) during sintering and bonding. In this regard, as for the content percentage of the sinterable particles, as the number of sinterable particles increases, the viscosity of the sintering-bonding sheet is likely to be kept high even when heated, the sinterable particles are less likely to leak from between adherends, the sintered body is likely to have a dense structure even after sintering and bonding, and high bonding strength and reliability are likely to be secured. On the other hand, when the number of sinterable particles is too small, the viscosity tends to be low due to other organic components and the like by heating or pressurization during sintering and bonding, and thus the sinterable particles and the binder tend to leak out from between the adherends. The sintered body after sintering and bonding tends to have many voids and may be weakened.

### <Organic binder>

As the organic binder contained in the sintering-bonding sheet, an appropriate type of organic binder can be adopted depending on the constituent metal of the sinterable particles, the surface treatment of the surface of the sinterable particles, and the like.

Examples of the organic binder include an organic binder composed of a polymer (with a molecular weight of about 1000 or more) material, at least part of which is thermally decomposed at a common sintering temperature (e.g., heating at about 300°C or higher). The organic binder is preferably made of a polymer material in which 50% or more of the polymer material is thermally decomposed at 300°C. It is preferable that the organic binder is not thermally decomposed before being heated to the above sintering temperature so that the sheet shape of the sintering-bonding sheet can be maintained. Therefore, the organic binder is preferably a solid material at normal temperature (23°C). Examples of the organic binder include a polycarbonate resin and/or an acrylic resin. When these materials are applied, it is easy to prevent the organic residues derived from the organic binder from remaining in the layer after sintering.

According to the organic binder as described above, when a bonding target is temporarily fixed before sintering, it is easy to secure adhesion to the bonding target by using viscoelasticity of the organic binder at a temporary fixing temperature (e.g., about 70°C). In addition, use of the sintering-bonding sheet containing the organic binder makes it easy to prevent the occurrence of positional deviation of the bonding target when the bonding targets are pressure-bonded to each other or after the pressure-bonding.

When the organic binder of the sintering-bonding sheet contains a polycarbonate resin and/or an acrylic resin, the organic binder is decomposed by sintering and easily disappears. Therefore, when these organic binders are used, the organic residues in the layer after sintering are easily reduced. When the amount of organic residues remaining after sintering is small, the bonding target is firmly bonded, and high bonding reliability is easily obtained.

Examples of the polycarbonate resin include an aliphatic polycarbonate and an aromatic polycarbonate. Here, the aliphatic polycarbonate is free of an aromatic compound in the main chain and is composed of an aliphatic chain. The aromatic polycarbonate contains an aromatic compound in the main chain. The main chain of polycarbonate herein refers to a chain having a carbonate group.

Examples of the aliphatic polycarbonate include polyethylene carbonate and polypropylene carbonate. Examples of the aromatic polycarbonate include a polycarbonate containing a bisphenol A structure in the main chain.

Examples of the acrylic resin include polymers of acrylic acid esters and methacrylic acid esters. These polymers may have a linear or branched alkyl group(s), and preferably have a hydrocarbon chain length of 4 to 18 carbon atoms. Note that as used herein, the term "(meth)acryl" represents both or any of "acryl" and "methacryl".

Examples of the alkyl group of the (meth)acrylic acid ester include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, and an octadecyl group.

The acrylic resin may be a polymer containing a monomer unit derived from a monomer other than the (meth)acrylic acid ester. Examples of such other monomers include a carboxy group-containing monomer, an acid anhydride monomer, a hydroxy group-containing monomer, a sulfonic acid group-containing monomer, and a phosphoric acid group-containing monomer. Examples of the carboxy group-containing monomer include acrylic acid, methacrylic acid, carboxyethyl acrylate, carboxypentyl acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and 4-(hydroxymethyl) cyclohexylmethyl (meth)acrylate. Examples of the sulfonic acid group-containing monomer include styrene sulfonic acid, allyl sulfonic acid, 2-(meth)acrylamide-2-methylpropane sulfonic acid, (meth)acrylamide propane sulfonic acid, sulfopropyl (meth)acrylate, and (meth)acryloyloxy naphthalene sulfonic acid. Examples of the phosphoric acid group-containing monomer include 2-hydroxyethyl acryloyl phosphate.

The organic binder preferably contains a polycarbonate resin, and more preferably contains a polyalkylene carbonate. The polyalkylene carbonate is a polymer having a repeating unit of -OC(=O)-O-CₙH₂ₙ- (where n is an integer of 2 to 12). Since the organic binder has a relatively low thermal decomposition temperature (about 300°C), the organic binder more preferably contains at least one selected from the group consisting of polypropylene carbonate (PPC) and polyethylene carbonate (PEC).

The organic binder particularly preferably contains polyethylene carbonate. When the organic binder is polyethylene carbonate, thermal decomposition at the time of sintering of the organic binder is likely to be particularly promoted by the amine-based additive, and it is considered that the inclusion of a highly reducng gas in the gas at the time of thermal decomposition improves the sintering performance at a low temperature. In addition, when the amine-based additive contains an alcoholamine, it is easy to strengthen the sheet property when the sintering-bonding sheet is formed.

The organic binder may contain both polyethylene carbonate and polypropylene carbonate. In this case, the content (mass) of polyethylene carbonate is preferably larger than the mass of polypropylene carbonate. The content ratio (mass ratio) between the polyethylene carbonate and the polypropylene carbonate may be in the range of 5:5 to 10:0 or in the range of 6:4 to 9:1.

The weight average molecular weight of the organic binder is preferably 10,000 or more. Within the above range, the viscoelasticity of the organic binder can be utilized to readily ensure the cohesive strength of the sintering-bonding sheet (e.g., its tendency to form a tough sheet encapsulating the sinterable particles) and its adhesive strength. The weight average molecular weight of the organic binder can be measured by gel permeation chromatography (GPC) and calculated in terms of polystyrene.

The content percentage of the organic binder in the sintering-bonding sheet is preferably 0.5 to 10.0 mass%, more preferably 0.8 to 8.0 mass%, and particularly preferably 1.0 to 6.0 mass%. When the content percentage of the organic binder is within the above range, it is easy to maintain an appropriate shape of the sintering-bonding sheet.

The organic binder may further contain a low-molecular-weight organic binder (with a molecular weight of less than 1000). In addition, the low-molecular-weight organic binder is preferably a low-boiling-point organic binder. The low-boiling-point organic binder is a binder component in which thermal decomposition (weight reduction) is started at a temperature (e.g., about 200°C) lower than the thermal decomposition start temperature of the polymer binder.

The low-molecular-weight organic binder is preferably a liquid or semi-liquid having a viscosity of 1 × 10⁵ Pa·s or less at 23°C as measured using a dynamic viscoelasticity meter (Trade name: "HAAKE MARS III", manufactured by Thermo Fisher Scientific). The above measurement can be performed using a parallel plate of 20 mmφ with an inter-plate gap of 100 µm and a shear rate in rotational shearing of 1 s⁻¹.

Examples of the low-molecular-weight organic binder include terpene alcohols, alcohols other than terpene alcohols, alkylene glycol alkyl ethers, and ethers other than alkylene glycol alkyl ethers. Examples of the terpene alcohols include isobornyl cyclohexanol, citronellol, geraniol, nerol, carbeol, and α-terpineol. Examples of the alcohols other than terpene alcohols include pentanol, hexanol, heptanol, octanol, 1-decanol, ethylene glycol, diethylene glycol, propylene glycol, butylene glycol, and 2,4-diethyl-1,5-pentanediol. Examples of the alkylene glycol alkyl ethers include ethylene glycol butyl ether, diethylene glycol methyl ether, diethylene glycol ethyl ether, diethylene glycol butyl ether, diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, and tripropylene glycol dimethyl ether. Examples of the ethers other than alkylene glycol alkyl ethers include ethylene glycol ethyl ether acetate, ethylene glycol butyl ether acetate, diethylene glycol ethyl ether acetate, diethylene glycol butyl ether acetate, dipropylene glycol methyl ether acetate, and ethylene glycol phenyl ether. The low-molecular-weight organic binder may be one kind or two or more kinds. The low-molecular-weight organic binder is preferably terpene alcohols and more preferably isobornyl cyclohexanol from the viewpoint of stability at room temperature.

The sintering-bonding sheet may contain a component(s) other than the above components. The sintering-bonding sheet may contain, for example, a plasticizer.

### <Physical properties>

The thickness of the sintering-bonding sheet is preferably 5 µm or more, and more preferably 10 µm or more. The thickness of the sintering-bonding sheet is preferably 500 µm or less, and more preferably 400 µm or less. When the thickness is within the above range, handleability during semiconductor production is easily maintained, and sinterable particles hardly protrude from between adherends during sintering.

The porosity of the sintering-bonding sheet may be 30% or less, 20% or less, or 15% or less. The porosity may be 0%, and is preferably 1% or more from the viewpoint of easily maintaining appropriate flexibility of the sheet. When the porosity is in the above range, the sinterable particles after sintering exist at a high density, and it is easy to realize highly reliable bonding. The porosity of the sintering-bonding sheet can be measured in the sintered layer after the sintering-bonding sheet is heated and sintered at 230°C for 5 minutes under conditions at a pressure of 15 MPa.

Each component contained in the sintering-bonding sheet can be measured by the following analysis procedure.

The sintering-bonding sheet is subjected to solvent extraction with a solvent such as methanol, acetone, ethyl acetate, methylene chloride, chloroform, or hexane, and an organic component derived from the organic binder is dissolved in the solvent and removed. After solvent extraction, the sinterable particles remaining as a solid are isolated.

The components of the organic binder can be measured by qualitatively analyzing the solvent after solvent extraction by infrared absorption spectroscopy (IR), gas chromatography mass spectrometry (GC/MAS), liquid chromatography mass spectrometry (LC/MS), or the like.

The components of the surface treatment agent on the sinterable particles can be identified by detecting organic decomposition products derived from the surface treatment agent using pyrolysis gas chromatography (GC/MAS). Alternatively, after cleaving the bonds between the conductive metal and components such as carboxylic acids in the surface treatment agent by high-temperature methanol decomposition, the components of the surface treatment agent can be measured by LC/MS or GC/MAS.

### (Sintering-bonding-use composition)

The sintering-bonding sheet can be produced using a sintering-bonding-use composition or a sintering-bonding-use varnish.

The sintering-bonding-use composition includes sinterable particles containing a conductive metal, an organic binder, and an amine-based additive.

As the sinterable particles, the organic binder, and the amine-based additive contained in the sintering-bonding-use composition, those similar to the above sintering-bonding sheet may be applied.

The content percentage of the sinterable particles in the sintering-bonding-use composition is preferably 83 to 98 mass%, more preferably 85 to 98 mass%, and particularly preferably 86 to 93 mass%. When the content percentage of the sinterable particles is within the above range, the bonded portion after sintering easily maintains high thermal conductivity, the sinterable particles hardly leak from between adherends at the time of sintering and bonding, and the tackiness of the sheet is also easily maintained. In addition, when the content percentage of the sinterable particles is increased, the sintered body after sintering and bonding tends to have a dense structure, and high bonding strength and reliability are easily secured.

### (Sintering-bonding-use varnish)

The sintering-bonding-use varnish includes sinterable particles containing a conductive metal, an organic binder, an amine-based additive, and a dispersion solvent.

As the sinterable particles, the organic binder, and the amine-based additive contained in the sintering-bonding-use varnish, those similar to the above sintering-bonding sheet may be used.

With such a sintering-bonding-use varnish, it is easy to form a sintering-bonding sheet in which the raw materials are easily uniformly dispersed in the varnish and the sinterable particles hardly protrude from between the adherends even by heating or pressurization during sintering. This results in a sintering-bonding sheet in which particle unevenness and cracking and chipping during processing hardly occur.

### <Dispersion solvent>

The dispersion solvent used and contained in the sintering-bonding-use varnish may be an organic solvent and/or an alcohol solvent.

Examples of the organic solvent include dimethylformamide, dimethylacetamide, N-methylpyrrolidone, acetone, methyl ethyl ketone, cyclohexanone, toluene, and xylene. Examples of the alcohol solvent include ethylene glycol, diethylene glycol, 1,2-propanediol, 1,3-propanediol, 1,2-butanediol, 1,3-butanediol, 1,4-butanediol, 2-butene-1,4-diol, 1,2,6-hexanetriol, glycerin, octanediol, 2-methyl-2,4-pentanediol, and terpineol.

### (Dicing tape)

The sintering-bonding sheet is preferably used, together with a dicing tape, in a semiconductor production process.

The dicing tape preferably includes a base material and an adhesive layer laminated on the base material. A sintering-bonding sheet-attached dicing tape including the sintering-bonding sheet of the present invention laminated on an adhesive layer of the dicing tape is suitably used in a semiconductor production process.

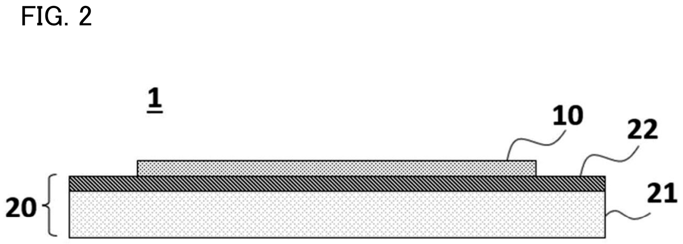

FIG. 2 is a schematic cross-sectional view showing an example of a sintering-bonding sheet-attached dicing tape. Hereinafter, FIG. 2 is used for description.

The sintering-bonding sheet-attached dicing tape 1 includes a dicing tape 20 having a base material 21 and an adhesive layer 22. The sintering-bonding sheet-attached dicing tape 1 also includes a sintering-bonding sheet 10 laminated on the adhesive layer 22.

The sintering-bonding sheet 10 may have the same shape as or a different shape from the shape of the dicing tape 20. The sintering-bonding sheet 10 may have any shape in plan view, and may have, for example, a rectangular shape, a circular shape, or the like. Further, one dicing tape 20 may have a plurality of sintering-bonding sheets 10.

The sintering-bonding sheet-attached dicing tape 1 may have any layer other than the above layers.

### <Adhesive layer>

The adhesive layer 22 can function as a layer to which the base material 21 and the sintering-bonding sheet 10 can be attached. The adhesive layer 22 is not necessarily provided on the entire surface of the base material 21, and may be provided only at a position corresponding to the sintering-bonding sheet 10. In addition, the adhesive layer 22 is not necessarily formed in a layer shape, and for example, may be provided in a discontinuous shape so as to have a dot shape or a stripe shape with respect to a plan view of the base material 21.

Examples of the adhesive used to form the adhesive layer include an acrylic adhesive based on an acrylic polymer and a rubber-based adhesive. In addition, the adhesive may be an adhesive (adhesive strength reduction type adhesive) capable of reducing the adhesive strength by an external action such as heating or radiation irradiation. In addition, the adhesive may be an adhesive, the adhesive strength of which is not reduced at all (or hardly) by an external action (adhesive strength non-reduction type adhesive). Examples of the adhesive strength reduction type adhesive include a radiation-curable adhesive (adhesive having radiation curability) and a heat foaming type adhesive. Examples of the adhesive strength non-reduction type adhesive include a pressure-sensitive adhesive.

When the adhesive contains an acrylic adhesive, the acrylic polymer as a base of the acrylic adhesive preferably contains a monomer unit derived from an alkyl acrylate and/or an alkyl methacrylate. In addition, it is preferable that the monomer unit is contained as a monomer unit having the largest mass ratio in the adhesive.

Examples of the (meth)acrylic acid alkyl ester include (meth)acrylic acid alkyl esters having a linear or branched alkyl group and (meth)acrylic acid cycloalkyl esters. Examples of the (meth)acrylic acid alkyl ester include methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, and eicosyl ester of (meth)acrylic acid. Examples of the (meth)acrylic acid cycloalkyl ester include cyclopentyl ester and cyclohexyl ester of (meth)acrylic acid. Only one kind of (meth)acrylic acid alkyl ester may be used, or two or more kinds thereof may be used.

The percentage of the (meth)acrylic acid alkyl ester in all the monomer components is preferably 50 mass% or more. This is because when the content is within the above range, basic characteristics such as adhesive strength of the adhesive are suitably and easily exhibited.

The acrylic polymer may further contain a monomer unit derived from another monomer copolymerizable with the (meth)acrylic acid alkyl ester. Inclusion of these monomer units makes it easy to modify the cohesive strength, heat resistance, and the like. Examples of such a monomer include a carboxy group-containing monomer, an acid anhydride monomer, a hydroxy group-containing monomer, a sulfonic acid group-containing monomer, a phosphoric acid group-containing monomer, acrylamide, and acrylonitrile. Examples of the carboxy group-containing monomer include acrylic acid, methacrylic acid, carboxyethyl (meth)acrylate, carboxypentyl (meth)acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and 4-(hydroxymethyl) cyclohexylmethyl (meth)acrylate. Examples of the sulfonic acid group-containing monomer include styrene sulfonic acid, allyl sulfonic acid, 2-(meth)acrylamide-2-methylpropane sulfonic acid, (meth)acrylamide propane sulfonic acid, sulfopropyl (meth)acrylate, and (meth)acryloyloxy naphthalene sulfonic acid. Examples of the phosphate group-containing monomer include 2-hydroxyethyl acryloyl phosphate. The other monomer may be one kind of monomer or two or more kinds of monomers.

The percentage of the monomer other than the (meth)acrylic acid alkyl ester in all the monomer components constituting the acrylic polymer is preferably 50 mass% or less. This is because when the percentage is within the above range, basic characteristics such as adhesive strength of the adhesive are suitably and easily exhibited.

The acrylic polymer may further contain a monomer unit derived from a polyfunctional monomer copolymerizable with the (meth)acrylic acid alkyl ester to form a crosslinked structure in the polymer skeleton. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylate, glycidyl (meth)acrylate, polyester (meth)acrylate, and urethane (meth)acrylate. The polyfunctional monomer may be one kind of monomer or two or more kinds of monomers.

The percentage of the polyfunctional monomer in all the monomer components is preferably 40 mass% or less. This is because when the percentage is within the above range, basic characteristics such as adhesive strength of the adhesive are suitably and easily exhibited.

The adhesive may contain, for example, an external crosslinking agent in order to increase the number average molecular weight of the base polymer such as an acrylic polymer. Examples of the external crosslinking agent include a polyisocyanate compound, an epoxy compound, an aziridine compound, and a melamine-based crosslinking agent. The content of the external crosslinking agent in the adhesive is preferably 5 mass% or less based on 100 mass% of the base polymer. This is because when the content is within this range, basic characteristics such as adhesive strength of the adhesive are suitably and easily exhibited.

The adhesive may be a radiation-curable adhesive that increases the degree of polymer crosslinking at a site irradiated with radiation such as ultraviolet rays to lower the adhesive strength. Examples of the radiation-curable adhesive include an addition-type radiation-curable adhesive. This addition-type radiation-curable adhesive contains a base polymer such as an acrylic polymer, and a radiation-polymerizable monomer component or oligomer component having a functional group such as a radiation-polymerizable carbon-carbon double bond.

Examples of the radiation-polymerizable monomer component include urethane (meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, and 1,4-butanediol di (meth)acrylate. Examples of the radiation-polymerizable oligomer component include urethane-based, polyether-based, polyester-based, polycarbonate-based, and polybutadiene-based oligomers. The oligomer component preferably has a molecular weight of about 100 to 30,000. The content of the monomer component and the oligomer component in the radiation-curable adhesive may be determined, if appropriate, within a range in which the adhesive strength can be reduced. For example, the content of the monomer component and the oligomer component is preferably 40 to 150 mass% based on 100 mass% of the base polymer.

As the addition-type radiation-curable adhesive, for example, the adhesive disclosed in JP 60-196956 A may be used.

Examples of the adhesive include an intrinsic radiation-curable adhesive. The intrinsic radiation-curable adhesive contains a base polymer having a functional group such as a radiation-polymerizable carbon-carbon double bond in a polymer side chain, in a polymer main chain, or at a polymer main chain terminal. The intrinsic radiation-curable adhesive makes it easy to suppress an unintentional temporal change of the adhesive property due to movement of a low-molecular-weight component in the adhesive.

The base polymer contained in the intrinsic radiation-curable adhesive preferably has an acrylic polymer as a basic skeleton. As the acrylic polymer, the acrylic polymer described above can be used. Examples of a method for introducing a radiation-polymerizable carbon-carbon double bond into an acrylic polymer include the following methods. First, a raw material monomer containing a monomer having a given functional group (first functional group) is copolymerized to produce an acrylic polymer. Thereafter, a compound having a given functional group (second functional group) capable of reacting with and bonding to the first functional group and a radiation-polymerizable carbon-carbon double bond is subjected to a condensation reaction or an addition reaction using the acrylic polymer. This condensation reaction or addition reaction is performed so as to maintain the radiation polymerization performance of the carbon-carbon double bond.

Examples of the combination of the first functional group and the second functional group include a carboxy group and an epoxy group, an epoxy group and a carboxy group, a carboxy group and an aziridyl group, an aziridyl group and a carboxy group, a hydroxy group and an isocyanate group, and an isocyanate group and a hydroxy group. Among these combinations, a combination of a hydroxy group and an isocyanate group and a combination of an isocyanate group and a hydroxy group are suitable from the viewpoint of ease of reaction tracking.

Here, it is technically difficult to prepare a polymer having a highly reactive isocyanate group. Thus, from the viewpoint of ease of preparation or availability, the case where the first functional group on the acrylic polymer side is a hydroxy group and the second functional group is an isocyanate group is more suitable as a combination. Examples of the isocyanate compound having both a radiation-polymerizable carbon-carbon double bond and an isocyanate group as the second functional group include methacryloyl isocyanate, 2-methacryloyloxyethyl isocyanate, and m-isopropenyl-α,α-dimethylbenzyl isocyanate. As the acrylic polymer having the first functional group, a polymer containing a monomer unit derived from a hydroxy group-containing monomer is suitable, and a polymer containing a monomer unit derived from an ether-based compound such as 2-hydroxyethyl vinyl ether, 4-hydroxybutyl vinyl ether, or diethylene glycol monovinyl ether is suitable.

The radiation-curable adhesive also preferably contains a photopolymerization initiator. Examples of the photopolymerization initiator include α-ketol-based compounds, acetophenone-based compounds, benzoin ether-based compounds, ketal-based compounds, aromatic sulfonyl chloride-based compounds, photoactive oxime-based compounds, benzophenone-based compounds, thioxanthone-based compounds, camphorquinone, halogenated ketones, acyl phosphinoxides, and acyl phosphonates. Examples of the α-ketol-based compound include 4-(2-hydroxyethoxy)phenyl(2-hydroxy-2-propyl)ketone, α-hydroxy-α,α'-dimethylacetophenone, 2-methyl-2-hydroxypropiophenone, and 1-hydroxycyclohexyl phenyl ketone. Examples of the acetophenone-based compound include methoxyacetophenone, 2,2-dimethoxy-2-phenylacetophenone, 2,2-diethoxyacetophenone, and 2-methyl-1-[4-(methylthio)-phenyl]-2-morpholinopropane-1. Examples of the benzoin ether-based compound include benzoin ethyl ether, benzoin isopropyl ether, and anisoin methyl ether. Examples of the ketal-based compound include benzyl dimethyl ketal. Examples of the aromatic sulfonyl chloride-based compound include 2-naphthalenesulfonyl chloride. Examples of the photoactive oxime-based compound include 1-phenone-1,2-propanedione-2-(O-ethoxycarbonyl)oxime. Examples of the benzophenone-based compound include benzophenone, benzoylbenzoic acid, and 3,3'-dimethyl-4-methoxybenzophenone. Examples of the thioxanthone-based compound include thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone.

The content of the photopolymerization initiator in the radiation-curable adhesive is preferably 0.05 to 20 mass% based on 100 mass% of the base polymer.

In addition to the components described above, the adhesive may optionally contain an additive(s) such as a crosslinking accelerator, a tackifier, an anti-aging agent, and/or a colorant. The colorant may be a compound (e.g., leuco dye) that is colored by irradiation with radiation.

In addition, the acrylic polymer described above may be obtained by polymerizing a raw material monomer(s). Examples of the polymerization method include solution polymerization, emulsion polymerization, bulk polymerization, and suspension polymerization. The amount of low-molecular-weight component in the adhesive is preferably small, and the number average molecular weight of the acrylic polymer is preferably 100,000 or more. Within the above range, it is easy to make the cleaning performance suitable when the sintering-bonding sheet-attached dicing tape is used for semiconductor production.

The viscosity of the adhesive is preferably 5 × 10³ to 1 × 10⁷ Pa·s, and more preferably 1 × 10⁴ to 1 × 10⁶ Pa·s. When the viscosity is within the above range, it is easy to maintain the adhesion between the sintering-bonding sheet 10 and the base material 21 in the semiconductor production process. The viscosity of the adhesive layer 22 can be measured by the same method as for the sintering-bonding-use composition.

The thickness of the adhesive layer 22 in the cross-sectional direction is preferably 5 µm or more, and more preferably 10 µm or more. The thickness is preferably 100 µm or less, and more preferably 80 µm or less. This is because when the thickness is within the above range, the organic binder tends to be easily decomposed and disappear while adhesion between the sintering-bonding sheet 10 and the base material 21 is maintained in a semiconductor production process. The thickness of the adhesive layer 22 can be measured by observing a cross section of the dicing tape with an electron microscope at 23°C.

### <Base material>

The base material 21 functions as a support in the dicing tape 20.

Examples of the base material 21 include a plastic base material. As the plastic base material, a plastic film is preferably used. Examples of the plastic base material include polyolefin, polyester, polyurethane, polycarbonate, polyether ether ketone, polyimide, polyetherimide, polyamide, wholly aromatic polyamide, polyvinyl chloride, polyvinylidene chloride, polyphenyl sulfide, aramid, fluororesin, cellulose-based resin, and silicone resin. Examples of the polyolefin include low-density polyethylene, linear low-density polyethylene, medium-density polyethylene, high-density polyethylene, ultra-low-density polyethylene, random copolymerized polypropylene, block copolymerized polypropylene, homopolypropylene, polybutene, polymethylpentene, an ethylene-vinyl acetate copolymer, an ionomer resin, an ethylene-(meth)acrylic acid copolymer, an ethylene-(meth)acrylic acid ester copolymer, an ethylene-butene copolymer, and an ethylene-hexene copolymer. Examples of the polyester include polyethylene terephthalate, polyethylene naphthalate, and polybutylene terephthalate.

The material for forming the base material 21 may be one kind or two or more kinds.

The base material 21 may be configured as a single layer or may have a multilayer structure.

When the base material 21 is made of a plastic film, the base material 21 may be an unstretched film, a uniaxially stretched film, or a biaxially stretched film.

The main surface of the base material 21 on the adhesive layer 22 side may be subjected to a surface treatment for enhancing adhesion with the adhesive layer 22. Examples of the surface treatment include physical treatments such as corona discharge treatment, plasma treatment, sand-mat processing, ozone exposure treatment, flame exposure treatment, high-voltage discharge exposure treatment, and ionizing radiation treatment; chemical treatments such as chromic acid treatment; and primer coating treatments.

The thickness of the base material 21 is preferably 40 µm or more, more preferably 50 µm or more, and particularly preferably 55 µm or more. Within the above range, it is easy for the base material 21 to secure strength as a support. In addition, the thickness of the base material 21 is preferably 200 µm or less, more preferably 180 µm or less, and particularly preferably 150 µm or less. Within the above range, the base material 21 has appropriate flexibility, and handleability such as tackiness is easily improved in semiconductor production.

The sintering-bonding sheet-attached dicing tape can be produced, for example, as follows.

First, the adhesive layer 22 is provided on the base material 21 to prepare the dicing tape 20. For example, the resin base material 21 may be prepared by film formation by calendering, a casting method in an organic solvent, an inflation extrusion method in a sealed system, a T-die extrusion method, a coextrusion method, a dry lamination method, or the like.

In order to provide the adhesive layer 22, first, an adhesive composition for forming the adhesive layer 22 is prepared. This adhesive composition is applied onto the base material 21 or a predetermined separator (release liner) to form an adhesive composition layer. The adhesive composition layer is dried as necessary (thermally crosslinked as necessary). At this time, examples of the method for applying the adhesive composition include roll coating, screen coating, and gravure coating. The temperature for drying the adhesive composition layer may be, for example, 80 to 150°C. The drying time may be, for example, 0.5 to 5 minutes. When the adhesive layer 22 is formed on the separator, the adhesive layer 22 with the separator is bonded to the base material 21.

The sintering-bonding sheet 10 may be prepared, for example, by applying the above-described sintering-bonding-use varnish onto a separator. Specifically, the prepared varnish is applied onto a predetermined separator to form a coating film, and the coating film is dried to obtain the sintering-bonding sheet 10 prepared on the separator.

The sintering-bonding sheet 10 can be attached to a dicing tape by the following procedure.

For example, the sintering-bonding sheet 10 is pressure-bonded to the dicing tape 20 on the adhesive layer 22 side. The temperature at the time of bonding is preferably 30 to 50°C. The pressure (linear pressure) is preferably 0.1 to 20 kgf/cm. When the adhesive layer 22 is a radiation-curable adhesive, the adhesive layer 22 may be irradiated with radiation such as ultraviolet rays from the base material 21 side. The irradiation dose is preferably 50 to 500 mJ/cm², and more preferably 100 to 300 mJ/cm². The region to be irradiated (irradiation region D) may be, for example, the adhesive layer 22 in a region (e.g., a central portion of the sintering-bonding sheet) excluding the peripheral edge portion where the sintering-bonding sheet is bonded.

The sintering-bonding sheet-attached dicing tape may have a separator (for protection before use) on the sintering-bonding sheet 10 (main surface opposite to the adhesive layer 22). When the separator is provided, the sintering-bonding sheet 10 and the adhesive layer 22 can be protected from being exposed. The separator can be peeled off and used before use in semiconductor production or the like.

Examples of the separator include a polyethylene terephthalate (PET) film, a polyethylene film, a polypropylene film, various plastic films surface-coated with a release agent (e.g., a fluorine-based release agent or a long-chain alkyl acrylate-based release agent), and paper.

### <Example of semiconductor device production method>

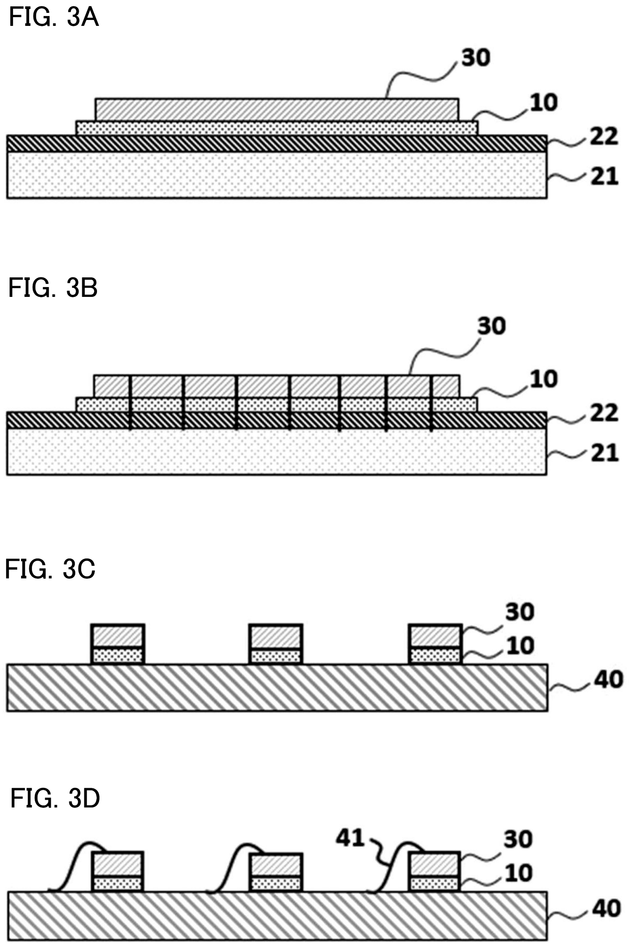

FIGS. 3A to 3D each show a part of the step of a semiconductor device production method using a sintering-bonding sheet-attached dicing tape in an embodiment.

First, as shown in FIG. 3A, a semiconductor wafer 30 is bonded to a sintering-bonding sheet 10 of a sintering-bonding sheet-attached dicing tape. Specifically, the semiconductor wafer 30 is pressed against the sintering-bonding sheet 10 by using a pressure roller or the like, and bonded to the sintering-bonding sheet 10. A plurality of semiconductor elements may be built in the semiconductor wafer 30, and a planar electrode may be formed as an external electrode on a main surface of the semiconductor wafer 30 on a side to be bonded to the sintering-bonding sheet 10. The thickness of the planar electrode is, for example, 10 to 1000 nm. As the planar electrode, for example, a planar electrode made of silver can be used. The planar electrode may be laminated on a thin titanium film formed on the semiconductor wafer. The thickness of the thin titanium film is preferably 10 to 1000 nm. The planar electrode and the thin titanium film can be formed by, for example, a vapor deposition process.

Another electrode pad or the like may be formed for each semiconductor element on the main surface of the semiconductor wafer 30 opposite to the sintering-bonding sheet 10.

The temperature at the time of bonding the semiconductor wafer 30 is preferably 50 to 90°C and the load is preferably 0.01 to 10 MPa. The adhesive layer 22 of the dicing tape may be formed of a radiation-curable adhesive. In this case, the adhesive layer 22 may be irradiated from the base material 21 side after the semiconductor wafer 30 is bonded, instead of irradiation with radiation during production of the dicing tape. The irradiation dose is preferably 50 to 500 mJ/cm², and more preferably 100 to 300 mJ/cm².

Next, as shown in FIG. 3B, the semiconductor wafer 30 is diced. Specifically, in a state where the semiconductor wafer 30 is bonded, the semiconductor wafer 30 is diced using a rotating blade such as a dicing device to be divided into semiconductor chip units (in the figure, each cut portion is schematically represented by a thick line). By dicing, each semiconductor chip with the sintering-bonding sheet 10 at a chip size is formed.

After dicing, a cleaning step of cleaning the semiconductor chip side by using a cleaning liquid such as water is performed as necessary. Thereafter, the sintering-bonding sheet-attached semiconductor chip is picked up from the dicing tape (pickup step). For example, the semiconductor chip to be picked up can be picked up by being sucked and held by a suction jig after using the pin member of the pickup mechanism.

As shown in FIG. 3C, the semiconductor chip picked up above is temporarily fixed to a support substrate 40 (temporary fixing step). Examples of the support substrate 40 include an insulating circuit substrate with wiring such as copper wiring on the surface and a lead frame. The region of the support substrate 40 on which the semiconductor chip is mounted may be the surface of a base material such as copper wiring or a lead frame, or it may be the surface of a plating film formed on the base material. Examples of the plating film include a gold (Au) plating film, a silver (Ag) plating film, a nickel (Ni) plating film, a palladium (Pd) plating film, and a platinum (Pt) plating film. The temperature condition for the temporary fixing is preferably 50 to 90°C, which is a temperature range including 70°C and its vicinity. The load condition of the pressing for temporary fixing is preferably 0.01 to 5 MPa, and the bonding time is preferably 0.01 to 5 seconds.

Thereafter, the semiconductor chip is heated at a high temperature for sintering and bonding, and bonded to the support substrate 40 (sintering-bonding step). The organic binder between the support substrate 40 and the semiconductor chip is thermally decomposed and volatilized by high temperature heating to sinter the conductive metal of the sinterable particles. As a result, a sintered layer is formed between the support substrate 40 and each semiconductor chip, and the support substrate 40 and the semiconductor chip are electrically connected. The temperature condition for sintering and bonding is preferably 250°C or lower, and more preferably 230°C or lower. The pressure condition for sintering and bonding is preferably 40 MPa or less, more preferably 20 MPa or less, and particularly preferably 15 MPa or less. The bonding time for sintering and bonding is preferably 0.3 to 300 minutes, and particularly preferably 0.5 to 240 minutes. The sintering-bonding step is preferably performed using a device capable of simultaneously performing heating and pressurization. Examples include a flip chip bonder and a parallel plate press. From the viewpoint of preventing oxidation of the metal, the sintering-bonding step is preferably performed under any of a nitrogen atmosphere, a reduced pressure, and a reducing gas atmosphere.

As shown in FIG. 3D, the electrode pad of the semiconductor chip is electrically connected to the terminal portion of the support substrate 40 via a bonding wire 41 as necessary (wire bonding step). In addition, a sealing resin may be formed in order to protect each semiconductor chip of the support substrate 40 and a bonding wire (sealing step).

As described above, a semiconductor device can be produced using a sintering-bonding sheet-attached dicing tape. However, the above is an example of the production method, and other production methods can be allowed. Examples

Hereinafter, the present invention will be described more specifically with reference to Examples. The present invention, however, is not limited to the following Examples.

### [Example 1]

Here, 920 parts by mass of commercially available copper nanoparticles a-1 as sinterable particles, 100 parts by mass of polyethylene carbonate PEC (weight average molecular weight: 180,000; trade name: QPAC25; manufactured by Empower Materials Inc.) as an organic binder, 2.5 parts by mass of triethanolamine TEA as an amine-based additive, and dimethyl succinate as a dispersion solvent were used and mixed at 2000 rpm for 120 seconds by using a hybrid mixer (ARE-310, manufactured by THINKY) such that the solid content in the varnish was 48 wt% to prepare a sintering-bonding-use varnish. The solid content in the varnish is defined as a numerical value obtained by calculating the weight of (copper nanoparticles + organic binder + amine-based additive)/the weight of (copper nanoparticles + organic binder + amine-based additive + dimethyl succinate) × 100.

The obtained varnish was applied onto a release-treated film (MRV(08T)50, manufactured by Mitsubishi Chemical Corporation) and dried to form a sheet having a thickness of 50 µm, thereby preparing a sintering-bonding sheet of Example 1. The drying temperature was 120°C, and the drying time was 2 minutes. The content percentage of the sinterable particles in the sintering-bonding sheet of Example 1 was 91.5 mass%.

### [Examples 2 to 10 and Comparative Examples 1 to 9]

Each of the sintering-bonding sheets of Examples 2 to 10 or Comparative Examples 1 to 9 was produced under the same conditions as in Example 1 except that the materials designated in Table 1 were used as the components (parts by mass) shown in Tables 2 and 3 in the preparation of each sintering-bonding-use varnish.

**[Table 1]**

| | | Materials |
|---|---|---|
| Sinterable particles | Cu | Copper nanoparticles; average particle diameter: 180 nm |
| Organic binder | PEC | Polyethylene carbonate (weight average molecular weight: 180,000, trade name QPAC25, manufactured by Empower Materials Inc.) |
| | PPC | Polypropylene carbonate (weight average molecular weight: 160,000, trade name QPAC40, manufactured by Empower Materials Inc.) |
| Amine-based additive | TEA | Triethanolamine, manufactured by Tokyo Chemical Industry Co., Ltd. |
| | BDEA | N-Butyldiethanolamine, manufactured by Tokyo Chemical Industry Co., Ltd. |
| | TBA | Tributylamine, manufactured by Tokyo Chemical Industry Co., Ltd. |
| | THA | Trihexylamine, manufactured by Tokyo Chemical Industry Co., Ltd. |
| | TOA | Trioctylamine, manufactured by Tokyo Chemical Industry Co., Ltd. |
| Dispersion solvent | DMSuc | Dimethyl succinate, manufactured by Tokyo Chemical Industry Co., Ltd. |

### [Evaluation]

For each of Examples and Comparative Examples, the sheet property was evaluated under the following conditions. In addition, after sintering and bonding under the following conditions, the bonding strength, the appearance after bonding, and the TG-TDA peak were evaluated. The results are shown in Tables 2 and 3.

### (Sheet property)

Each sintering-bonding sheet was observed and evaluated according to the following criteria. Note that the case where the sheet could not be peeled off as a single layer from the release-treated film was evaluated as × in the following evaluation.
⊙: The sheet is flexible and can be bent on its own, and it also has tackiness.
○: The sheet is flexible and can be bent on its own, but the tackiness is weak.
△: The sheet is brittle but can be handled as a single body.
×: The sheet is brittle, and it is difficult or impossible to handle the sheet as a single body.

### (Sintering process)

The sintering-bonding sheet of each Example or each Comparative Example was used for sintering and bonding as follows.

First, an Ag-plated Cu chip (3 mm square; thickness: 500 µm) was prepared.

Next, each sintering-bonding sheet was bonded onto the Ag-plated Cu chip by using a laminator including a pressure roller. The lamination temperature was 70°C, the load (pressure by the pressure bonding roll) was 0.3 MPa, and the speed of the pressure bonding roll was 10 mm/sec. As described above, each Ag-plated Cu chip having a sintering-bonding sheet of 3 mm square was obtained.

The sintering-bonding sheet-attached Ag-plated Cu chip was sinter-bonded to a solid Cu plate (thickness: 3 mm). Specifically, sintering was performed using a sintering device (HTM-3000, manufactured by Hakuto Co., Ltd.) such that the sintering-bonding sheet was positioned between the copper plate and the Ag-plated Cu chip. During sintering, the pressure applied in the thickness direction was 15 MPa, the heating temperature was 230°C, the heating time was 5 minutes under a N₂ atmosphere.

### (Appearance after sintering)

The appearance of the Ag-plated Cu chip sintered under the above conditions was observed and evaluated according to the following criteria.
○: In a front view of the Ag-plated Cu chip after sintering, no component derived from the sintering-bonding sheet was observed (the shape was maintained without protruding from the silicon chip).
△: In a front view of the Ag-plated Cu chip after sintering, a sintering-bonding sheet-derived component leaking to the outer periphery of the Ag-plated Cu chip was observed, but the Ag-plated Cu chip and the copper plate were bonded.
×: In a front view of the silicon chip after sintering, a sintering-bonding sheet-derived component markedly leaked to the outer periphery of the silicon chip, and the silicon chip and the copper plate were not bonded.

### (Bonding strength)

For the layer between the copper substrate and the Ag-plated Cu chip sintered and bonded under the above conditions, the shear bonding strength (MPa) was measured using a shear bonding strength tester (trade name: "DAGE 4000"; load cell used: DS-100; DAGE Inc.) at a measurement temperature of 23°C, and the measured value was defined as bonding strength. As shown in FIG. 1, the shear bonding strength was measured as the maximum stress when a load was applied in the shear direction from the side surface side of the Ag-plated Cu chip 30 by using blade B in a laminate including the sintered copper substrate 40, the sintered body 10A, and the Ag-plated Cu chip 30. The shear direction F is a direction parallel to the main surface of the copper substrate 40, and is a direction indicated by F in FIG. 1. The head height (height from the copper substrate) of the blade B was set to 50 µm (about 1.5 times the thickness of the sintered layer formed between the copper substrate and the Ag-plated Cu chip). The moving speed of the blade B was set to 50 µm/sec.

### (TG-DTA peak)

The sintering-bonding sheet of each Example or each Comparative Example was measured at a temperature rising rate of 10°C/min from 23°C to 400°C in a nitrogen atmosphere by a high-performance thermal analyzer (STA 200, manufactured by Hitachi High-Tech Science Corporation), and a weight loss curve was obtained. The peak temperatures of the obtained curves are shown in Tables 2 and 3.

**[Table 2]**

| | | | | Example | | | | | | | | | |
|---|---|---|---|---|---|---|---|---|---|---|---|---|---|
| | | | | 1 | 2 | 3 | 4 | 5 | 6 | 7 | 8 | 9 | 10 |
| Components | Sinterable particles | Cu | parts by mass | 933 | 956 | 980 | 1000 | 523 | 750 | 1230 | 956 | 1000 | 956 |
| | Binder | PEC | parts by mass | 100 | 100 | 100 | 100 | 100 | 100 | 100 | 100 | 100 | 50 |
| | | PPC | parts by mass | - | - | - | - | - | - | - | - | - | 50 |
| | Amine | TEA | parts by mass | 2.5 | 5 | 7.5 | 10 | 5 | 5 | 5 | - | - | 5 |
| | | BDEA | parts by mass | - | - | - | - | - | - | - | 5 | 10 | - |
| | | TBA | parts by mass | - | - | - | - | - | - | - | - | - | - |
| | | THA | parts by mass | - | - | - | - | - | - | - | - | - | - |
| | | TOA | parts by mass | - | - | - | - | - | - | - | - | - | - |
| | Solvent | DMSuc | parts by mass | Adjust solid content to 48 wt% | | | | | | | | | |
| Evaluation | Sheet property | | | Δ | ⊙ | ○ | ○ | ⊙ | ⊙ | Δ | ○ | Δ | Δ |
| | Bonding strength (MPa) | | | 70 | 70 | 70 | 70 | 70 | 70 | 80 | 70 | 70 | 60 |
| | Appearance after sintering | | | ○ | ○ | ○ | ○ | Δ | ○ | ⊙ | Δ | ○ | ○ |
| | Tg-DTA peak (°C) | | | 150 | 150 | 150 | 150 | 150 | 150 | 150 | 150 | 150 | 170 |

Abbreviation of each material in the components is the same as in Table 1.

**[Table 3]**

| | | | | Comparative Example | | | | | | | | |
|---|---|---|---|---|---|---|---|---|---|---|---|---|
| | | | | 1 | 2 | 3 | 4 | 5 | 6 | 7 | 8 | 9 |
| Components | Sinterable particles | Cu | parts by mass | 920 | 1092 | 956 | 956 | 956 | 910 | 956 | 1203 | 956 |
| | Binder | PEC | parts by mass | 100 | 100 | 100 | 100 | 100 | 100 | - | - | - |
| | | PPC | parts by mass | - | - | - | - | - | - | 100 | 100 | 100 |
| | Amine | TEA | parts by mass | 1 | 20 | - | - | - | - | 5 | 30 | - |
| | | BDEA | parts by mass | - | - | - | - | - | - | - | - | 5 |
| | | TBA | parts by mass | - | - | 5 | - | - | - | - | - | - |
| | | THA | parts by mass | - | - | - | 5 | - | - | - | - | - |
| | | TOA | parts by mass | - | - | - | - | 5 | - | - | - | - |
| | Solvent | DMSuc | parts by mass | Adjust solid content to 48 wt% | | | | | | | | |
| Evaluation | Sheet property | | | × | × | Δ | × | Δ | × × | Δ | Δ | Δ |
| | Bonding strength (MPa) | | | 10 | 10 | 20 | 20 | 15 | ND | 30 | 30 | 25 |
| | Appearance after sintering | | | ○ | ○ | ○ | ○ | ○ | ND | ○ | ○ | ○ |
| | Tg-DTA peak (°C) | | | 200 | 150 | 250 | 250 | 250 | ND | 200 | 120 | 130 |

| | | | | | | | | | | | | |
|---|---|---|---|---|---|---|---|---|---|---|---|---|
| ND: Not determined | | | | | | | | | | | | |

Abbreviation of each material in the components is the same as in Table 1.

From the above results, all of the sintering-bonding sheets of Examples 1 to 10 had a sheet property allowing for handling as a single body, and the bonding strength was 50 MPa or more. By contrast, all of the sintering-bonding sheets of Comparative Examples 1 to 9 had a bonding strength of less than 50 MPa, and the sintering-bonding sheets of Comparative Examples 1, 2, 4, and 6 were also difficult or impossible to handle as a single body in terms of sheet property. In addition, in the sintering-bonding sheets of Comparative Examples 7 to 9, the sintered body was likely to remain on the surface of the copper substrate during the measurement of the shear bonding strength. This may be because the organic binder was hardly decomposed or solid-phase diffusion between the sinterable particles was inhibited during sintering of the sintering-bonding sheet. In Comparative Examples 7 to 8, the Tg-DTA peak temperature was low, but the bonding strength was less than 50 MPa. This may be because the gas during thermal decomposition was a gas with low reducibility during sintering of polypropylene carbonate (PPC) as an organic binder, making it difficult to exert the effect of improving sintering performance.

## Claims

1. A sintering-bonding sheet comprising sinterable particles containing a conductive metal, an organic binder, and an amine-based additive, wherein
a bonding strength after sintering at 230°C under 15 MPa for 5 minutes is 50 MPa or higher.

2. The sintering-bonding sheet according to claim 1, wherein the organic binder contains polyethylene carbonate.

3. The sintering-bonding sheet according to claim 1, wherein the amine-based additive contains an amine represented by the following formula (1): 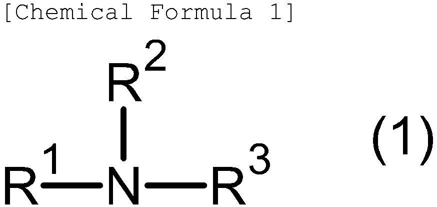
wherein in the above formula (1), R¹, R², and R³ each represent a C₁₋₃ hydroxyalkyl group or a C₁₋₅ alkyl group,
two or more of R¹, R², and R³ represent a C₁₋₃ hydroxyalkyl group, and
when any two of R¹, R², and R³ represent the hydroxyalkyl group, one other than the hydroxyalkyl group represents a C₁₋₅ alkyl group.

4. The sintering-bonding sheet according to claim 1, wherein the amine-based additive has a content of 1 to 20 mass% based on 100 mass% of the organic binder.

5. The sintering-bonding sheet according to claim 1, wherein the amine-based additive has a boiling point of 200 to 400°C.

6. The sintering-bonding sheet according to claim 3, wherein at least one of R¹, R², and R³ represents a C₂₋₃ hydroxyalkyl group.

7. The sintering-bonding sheet according to claim 1, wherein the amine-based additive contains at least one compound selected from the group consisting of triethanolamine and N-butyldiethanolamine.

8. The sintering-bonding sheet according to claim 1, wherein the sinterable particles are copper particles.

9. A sintering-bonding sheet-attached dicing tape comprising:
a dicing tape comprising a base material and an adhesive layer laminated on the base material; and
the sintering-bonding sheet according to any one of claims 1 to 8, the sheet being laminated on the adhesive layer.
